# EUROPÄISCHE PATENTSCHRIFT

(11) **EP 1 829 986 B1**
(45) Veröffentlichungstag und Bekanntmachung des Hinweises auf die Patenterteilung: **21.04.2010**
(21) Anmeldenummer: 07004064.7
(22) Anmeldetag: 27.02.2007
(51) Int. Cl.: C23C 14/56, C23C 14/58, C23C 16/26, C23C 16/27, C23C 14/06

(54) **Verfahren zur Bearbeitung von Oberflächen mit einer Beschichtung aus hartem Kohlenstoff**
Method for treating surfaces of a hard carbon coating
Procédé de fonctionnement de surfaces d'un revêtement en carbone dur

(30) Priorität: 01.03.2006 DE 102006010916
(43) Veröffentlichungstag der Anmeldung: 05.09.2007
(73) Patentinhaber: Fraunhofer-Gesellschaft zur Förderung der angewandten Forschung e.V., 80686 München (DE)
(72) Erfinder: Weihnacht, Volker, Dr.-Ing., 01309 Dresden (DE); Schultrich, Bernd, Prof. Dr. rer. nat. habil., 01257 Dreden (DE)
(74) Vertreter: Pfenning, Meinig & Partner GbR

(56) Entgegenhaltungen:
- US-A- 5 543 210
- US-A- 5 648 119
- US-B1- 6 284 315
- HITOSHI TOKURA ET AL: "STUDY ON THE POLISHING OF CHEMICALLY VAPOUR DEPOSITED DIAMOND FILM" THIN SOLID FILMS, ELSEVIER-SEQUOIA S.A. LAUSANNE, CH, Bd. 212, Nr. 1 / 2, 15. Mai 1992 (1992-05-15), Seiten 49-55, XP000360199 ISSN: 0040-6090
- TAKENO ET AL: "Tribological properties of partly polished diamond coatings" DIAMOND AND RELATED MATERIALS, ELSEVIER SCIENCE PUBLISHERS, AMSTERDAM, NL, Bd. 14, Nr. 11-12, November 2005 (2005-11), Seiten 2118-2121, XP005486473 ISSN: 0925-9635

## Beschreibung

Die Erfindung betrifft ein Verfahren zur Bearbeitung von Oberflächen einer Beschichtung aus hartem Kohlenstoff, die auf Substraten ausgebildet ist. Es können Beschichtungen verschiedenster Modifikationen von hartem, bzw. diamantähnlichem Kohlenstoff so bearbeitet werden, um eine Oberfläche der Beschichtung mit verbesserten Eigenschaften zur Verfügung zu stellen.

Beschichtungen aus hartem Kohlenstoff können mit unterschiedlichen Technologien auf Substraten ausgebildet werden. Die Kohlenstoffschichten können aus kristallinem Diamant oder amorphem Kohlenstoff bestehen, wobei letztere auch Legierungselemente, wie z.B. Wasserstoff, Stickstoff, Silicium oder auch metallische Elemente enthalten können.

Dabei tritt bei den Beschichtungen mehr oder weniger Fehlstellen, Schichtdickenschwankungen und auch zu einer rauhen Oberfläche führt, deren Eigenschaften für viele Anwendungen unzureichend sind. So ist eine Glättung von Oberflächen solcher Beschichtungen häufig gewünscht bzw. auch erforderlich, um entsprechende Bauteile für den jeweiligen Zweck einsetzen zu können.

Insbesondere Beschichtungen die mit einer als ta-C ( tetraedisch gebundener amorpher Kohlenstoff) bezeichneten Modifikation von diamantähnlichem Kohlenstoff gebildet sind, weisen neben einer sehr hohen Härte, die 4.000 HV übertreffen kann. Es treten gewöhnlich zu erhöhter Rauhheit führende Wachstumsdefekte auf. Derartige Rauheitsspitzen können bei der Ausbildung solcher Beschichtungen nur durch spezielle technologische Modifikationen (z.B. Partikelfilter) vermieden werden. Dies reduziert aber wiederum die Beschichtungsrate.

Bei der Abscheidung von Diamantschichten entsteht gewöhnlich eine durch die Kristallfacetten beeinflusste Oberflächenstruktur. Die Abscheidung nanokristalliner glatter Schichten ist mit deutlichen Verringerung der Beschichtungsrate verbunden, was die Herstellung unrentabel machen kann.

Für die Bearbeitung der Oberflächen von Diamantbeschichtungen sind neben dem klassischen mechanischen Polieren eine Reihe von Verfahren entwickelt worden, die sich in folgende Gruppen einteilen lassen: thermomechanisches, chemomechanisches, Plasma-, Ionenstrahl- sowie Laserpolieren: Diese Verfahren eignen sich auch für die Bearbeitung von harten amorphen Kohlenstoffschichten.

Die thermomechanischen Verfahren basieren auf einer thermisch aktivierten Zersetzungsreaktion des Diamants. So wird bei einer bisher eingesetzten Möglichkeit geschmolzenes Eisen oder eine Eisenlegierung in einer inerten Atmosphäre mit der Beschichtung kontaktiert und dabei Eisenkarbid gebildet, das in die Schmelze eindiffundiert. Neben dem ersichtlich hohen Aufwand können dadurch aber lokale Rauheitsspitzen nicht selektiv beseitigt werden, sondern es kommt zu einem Werkstoffabtrag über die gesamte so beeinflusste Oberfläche. Eine ähnliche Lösung, die jedoch kein geschmolzenes Eisen verwendet, sondern bei Temperaturen knapp unterhalb der Eisenschmelztemperatur arbeitet, ist in US 6, 284,315 beschrieben.

Eine verbreitete Technik ist eine Bearbeitung mit rotierenden Scheiben aus Eisen, Nickel oder Molybdän bei hohen Temperaturen und Drücken in inerter Atmoshäre (siehe. z.B. H. Tokura u.a.; Thin Solid Films 212/1-2 (1992) S. 49-55). Auch hier ist der Aufwand sowie die erforderliche Bearbeitungszeit hoch und es können lediglich ebene, unkonturierte und nicht gekrümmte Oberflächen bearbeitet werden.

Weitere Bearbeitungsverfahren mit Hilfe eines Plasmas, Ionenstrahls bzw. Lasers arbeiten Kontaktlos und sind auch für nicht-planare Oberflächen geeignet. Sie sind jedoch sehr aufwändig und bedingen Vakuumbedingungen bzw. kontrollierte Atmosphären.

Die bisher für eine gewünschte die Oberfläche glättende Bearbeitung bekannten Lösungen sind aufwändig und auf ebene oder begrenzt gekrümmte oder gewölbte Oberflächen beschränkt.

Es ist daher Aufgabe der Erfindung Möglichkeiten für die Bearbeitung von Oberflächen an Beschichtungen aus hartem Kohlenstoff, die zu einer Glättung führen, vorzuschlagen, die den Aufwand, die Kosten reduzieren und auch bei konturierten Oberflächen eingesetzt werden können.

Erfindungsgemäß wird diese Aufgabe mit einem Verfahren nach Anspruch 1 gelöst. Vorteilhafte Ausgestaltungen und Weiterbildungen können mit in den untergeordneten Ansprüchen bezeichneten Merkmalen erreicht werden.

Erfindungsgemäß erfolgt die Bearbeitung mechanisch unter Einsatz eines rotierenden Elementes an dem borstenförmige oder plattenförmige Elemente aus einem Metall vorhanden sind. Bei Rotation des rotierenden Elementes bewegen sich die stirnseitigen Enden der borstenförmigen oder plattenförmigen Elemente über die Oberfläche, befinden sich dabei in punktförmigen oder linienförmigen Kontakt mit der Oberfläche und es wird so eine Glättung des entsprechend bearbeiteten Bereichs erreicht.

Die borstenförmigen oder plattenförmigen Elemente können dabei gezielt über die Oberfläche bewegt werden, was insbesondere auf die Geschwindigkeit und die auf die Oberfläche ausgeübte Druckkraft zutrifft. Beide können einzeln oder auch gemeinsam gezielt gewählt werden. Dabei kann die jeweilige Beschichtung mit ihrer Konsistenz, die Oberflächengeometrie und auch die Dimensionierung einer Vorrichtung für die Bearbeitung berücksichtigt werden. Letztgenannter Aspekt betrifft wesentlich die jeweilige Größe der bearbeiteten Oberfläche.

Die borstenförmigen oder plattenförmigen Elemente sollten flexibel biegbar sein. Bevorzugt sollen sie aus einem eine Affinität zu Kohlenstoff aufweisenden Metall oder einer solchen Metalllegierung gebildet sein. Dies sind beispielsweise Eisen oder Stähle auch mit ihren Legierungen.

Sie können mit anderen, z.B. weichen Metallen kombiniert werden, die gezielt auf die Kohlenstoffoberfläche übertragen werden.

Die bei der Erfindung einsetzbaren rotierenden Elemente können also mit einer Vielzahl von Borsten oder Platten bestückt sein, wobei dann die borstenförmigen oder plattenförmigen Elemente orthogonal zur Rotationsachse ausgerichtet sein können. Plattenförmige Elemente sollten dabei parallel zueinander ausgerichtet und in einem Abstand zueinander angeordnet sein.

Es besteht aber auch die Möglichkeit borstenförmige oder plattenförmige Elemente mit Ausrichtung parallel oder beliebigen anderen Winkeln zur Rotationsachse an einem rotierenden Element vorzusehen. Diese bewegen sich dann jeweils entlang einer Kreisbahn über die Oberfläche einer zu bearbeitenden Oberfläche. Plattenförmige Elemente sollten hierbei in möglichst gleichen Winkelabständen zueinander ausgerichtet und in Abständen zueinander angeordnet sein.

Borstenförmige Elemente sollten unter Berücksichtigung der Bewegungsrichtung in versetzter Anordnung an einem rotierenden Element vorhanden sein.

Bei der Bearbeitung sollte die Bewegung borsten- oder plattenförmiger Elemente entlang der Oberfläche der Beschichtung mit einer Geschwindigkeit von mindestens 1 m/s erfolgen.

Überraschend hat sich herausgestellt, dass eine zum erfinderischen Erfolg führende Bearbeitung von Oberflächen einer Beschichtung eines Werkstoffes, der eine Härte aufweist, die erheblich größer, als ein Werkstoff von borstenförmigen oder plattenförmigen Elementen ist, möglich ist. Die Härte der für borstenförmige oder plattenförmige Elemente eingesetzten Werkstoffe kann unter 50% der Härte der die Beschichtung bildenden Kohlenstoff Modifikation bildenden Kohlenstoffs liegen. So liegt beispielsweise die Härte von Stahl üblicherweise bei ca. 700 HV.

Mit der Erfindung erfolgt eine Glättung mit Reduzierung der relativen Rauhtiefe nahezu unabhängig vom Ausgangszustand der Oberfläche der Beschichtung.

Die für die Bearbeitung erforderliche Zeit, auch unter Berücksichtigung der jeweils bearbeiteten Oberflächengröße kann gegenüber bekannten Lösungen reduziert werden. Durch eine entsprechende Auswahl eines mit borstenförmigen oder plattenförmigen Elementen bestückten rotierenden Elementes können unterschiedliche Oberflächengeometrien bearbeitet werden. So können konvexe oder auch konkave Oberflächen, Oberflächen mit Absätzen und ggf. auch Hinterschneidungen aufweisende Oberflächenbereiche erfindungsgemäß bearbeitet werden.

Durch die erfindungsgemäße Bearbeitung wirkt eine damit einhergehende lokal begrenzte Erwärmung im Kontaktbereich borstenförmiger oder plattenförmiger Elemente so, dass nicht nur Rauhigkeitsspitzen abgebaut, sondern auch eine Einebnung erreichbar wird. Bei der selektiven lokalen Erwärmung kann eine Graphitisierung erfolgen und es anschließend in der Beschichtung zu einem Abtransport von graphitisierten Werkstoff in der Beschichtung sowie zur Diffusion von Kohlenstoff in den Werkstoff von borsten- oder plattenförmigen Elementen kommen.

Rauhheitsspitzen werden mit entsprechend erhöhter Flächenpressung beim Kontakt mit borstenförmigen oder plattenförmigen Elementen beaufschlagt und dadurch sehr effektiv abgetragen und als solche beseitigt.

Nachdem die Rauhheitsspitzen im Wesentlichen abgetragen worden sind, wird eine deutlich größere Oberfläche bearbeitet und dann erfolgt, wenn überhaupt ein erheblich reduzierter Werkstoffabtrag der Beschichtung, so dass die Schicht in ihrer Ausgangsdicke weitestgehend erhalten bleibt.

Es kann auch mittels von in borsten- oder plattenförmigen Elementen enthaltenem Metall ein Werkstoffübertrag in nicht vollständig gefüllte Vertiefungen einer Beschichtung erreichen.

Bei der Bearbeitung kann eine Relativbewegung zwischen Substrat und rotierendem Element erfolgen.

Nachfolgend soll die Erfindung beispielhaft näher erläutert werden.

Dabei zeigen:
Figur 1 zwei Beispiele für rotierende Elemente, die für eine erfindungsgemäße Bearbeitung eingesetzt werden können und
Figur 2 ein Diagramm erreichbarer Rauhtiefen an verschiedenen Beschichtungsdicken eines Substrates.

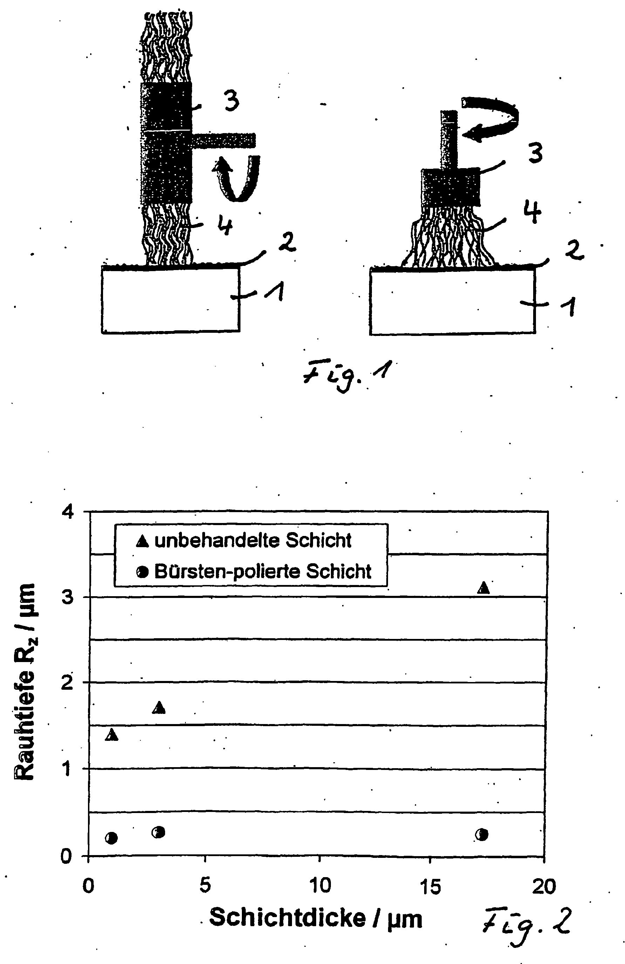

Mit Figur 1 sollen zwei geeignete rotierende Elemente 3, die mit einer Vielzahl von borstenförmigen Elementen 4 versehen sind, verdeutlicht werden. Die borstenförmigen Elemente 4 sind bei diesem Beispiel aus dünnem Stahldraht gebildet. In der linken Darstellung sind sie im Wesentlichen orthogonal zur Rotationsachse ausgerichtet und am rechts Dargestellten im Wesentlichen parallel dazu.

Ein rotierendes Element 3, gemäß der linken Darstellung von Figur 1 wurde mit einer Breite von 10 mm, einem maximalen Außendurchmesser von 80 mm eingesetzt. Die borstenförmigen Elemente 4 hatten einen Durchmesser von 0,3 mm. Die Rotation wurde bei einer Drehzahl von 1000 U/min durchgeführt, so dass eine Geschwindigkeit von 4 bis 5 m/s erreicht wurde.

Auf die Oberfläche wurde eine Druckkraft über die borstenförmigen Elemente 4 von 10 N ausgeübt und so eine Beschichtung aus ta-C bearbeitet. Die Bearbeitung einer 10 cm² großen Fläche konnte nach ca. 1 min mit gutem Erfolg beendet werden.

So ist dem in Figur 2 gezeigten Diagramm zu entnehmen, dass bei einer Ausgangsschichtdicke von ca. 1 µm, 3 µm und 17 µm jeweils die Rauhtiefe erheblich reduziert werden konnte.

## Patentansprüche

1. Verfahren zur Bearbeitung von Oberflächen einer Beschichtung aus einem hartem Kohlenstoff auf Substraten, bei dem borstenförmige oder plattenförmige Elemente (4) aus einem Metall, die mit einem rotierenden Element (3) verbunden sind, bei gleichzeitiger Rotation mit einer zu bearbeitenden Oberfläche der Beschichtung (2) in punkt- oder linienförmigen Kontakt gebracht und auf der Oberfläche bewegt werden, wobei die zu bearbeitende Oberfläche geglättet wird.

2. Verfahren nach Anspruch 1, **dadurch gekennzeichnet, dass** eine vorgebbare Geschwindigkeit und/oder Druckkraft, mit der die borsten- oder plattenförmigen Elemente (4) über die zu bearbeitende Oberfläche bewegt werden und auf die Oberfläche wirken, eingestellt wird.

3. Verfahren nach Anspruch 1 oder 2, **dadurch gekennzeichnet, dass** die borstenförmigen oder plattenförmigen Elemente (4) überwiegend aus einem eine Affinität zu Kohlenstoff aufweisenden Metall oder einer solchen Metalllegierung gebildet werden.

4. Verfahren nach einem der vorhergehenden Ansprüche, **dadurch gekennzeichnet, dass** flexibel biegbare borstenförmige oder plattenförmige Elemente (4) eingesetzt werden.

5. Verfahren nach einem der vorhergehenden Ansprüche, **dadurch gekennzeichnet, dass** die borstenförmigen oder plattenförmige Elementen (4) aus Eisen, einem Stahl oder einer Legierung davon gebildet werden.

6. Verfahren nach einem der vorhergehenden Ansprüche, **dadurch gekennzeichnet, dass** borstenförmige oder plattenförmige Elemente (4), die aus einem Werkstoff gebildet sind, dessen Härte kleiner als 50% der Härte des die Beschichtung (2) bildenden harten Kohlenstoffs ist, eingesetzt werden.

7. Verfahren nach einem der vorhergehenden Ansprüche, **dadurch gekennzeichnet, dass** die borstenförmigen oder plattenförmigen Elemente (4) mit einer Geschwindigkeit von mindestens 1 m/s entlang der Oberfläche der Beschichtung (2) bewegt werden.

8. Verfahren nach einem der vorhergehenden Ansprüche, **dadurch gekennzeichnet, dass** eine Beschichtung aus a-C, ta-C oder Diamant bearbeitet wird.

9. Verfahren nach einem der vorhergehenden Ansprüche, **dadurch gekennzeichnet, dass** über das den in den borstenförmigen oder plattenförmigen Elementen (4) enthaltene Metall eine Werkstoffübertragung in nicht vollständig gefüllte Vertiefungen in der Beschichtung (2) erreicht wird.

## Claims

1. A method for treating surfaces of a coating, of a hard carbon, on substrates, in which bristle-shaped or plate-shaped metal elements (4) connected to a rotating element (3) are, accompanied by simultaneous rotation, brought into punctiform or linear contact with a surface, to be treated, of the coating (2), moved on the surface and in the process the treated surface is made smooth.

2. A method according to claim 1, **characterised in that** a predeterminable speed and/or pressure force is set, at/with which bristle-shaped or plate-shaped elements (4) are moved over the surface to be treated and act upon the surface.

3. A method according to claim 1 or 2, **characterised in that** bristle-shaped or plate-shaped elements (4) predominantly of a metal with an affinity to carbon or of a metal alloy of that kind are used.

4. A method according to any one of the preceding claims, **characterised in that** flexibly bendable bristle-shaped or plate-shaped elements (4) are used.

5. A method according to any one of the preceding claims, **characterised in that** bristle-shaped or plate-shaped elements (4) of iron, a steel or an alloy thereof are used.

6. A method according to any one of the preceding claims, **characterised in that** bristle-shaped or plate-shaped elements (4) formed of a material whose hardness is less than 50% of the hardness of the hard carbon forming the coating (2) are used.

7. A method according to any one of the preceding claims, **characterised in that** the bristle-shaped or plate-shaped elements (4) are moved at a speed of at least 1 m/s along the surface of the coating (2).

8. A method according to any one of the preceding claims, **characterised in that** a coating of a-C, t-aC or diamond is treated.

9. A method according to any one of the preceding claims, **characterised in that** a material transfer into coating depressions which are not completely filled is achieved via the metal contained in the bristle-shaped or plate-shaped elements.

## Revendications

1. Procédé de traitement de surfaces d'un revêtement formé d'un carbone dur sur des substrats, dans lequel des éléments (4) en métal, en forme de soies ou de plaques, qui sont raccordés à un élément rotatif (3), sont amenés en contact en forme de points ou de lignes par rotation simultanée & avec une surface à traiter du revêtement (2) et déplacés sur la surface, dans lequel la surface à traiter est lissée.

2. Procédé selon la revendication 1, **caractérisé en ce que** l'on règle une vitesse et/ou une forte de pression prédéfinissable(s), avec laquelle ou lesquelles les éléments (4) en forme de soies ou de plaques sont déplacés sur la surface à traiter et agissent sur la surface.

3. Procédé selon la revendication 1 ou 2, **caractérisé en ce que** les éléments (4) en forme de soies ou de plaques sont formés principalement d'un métal présentant une affinité pour le carbone ou d'un alliage de ce métal.

4. Procédé selon Tune quelconque des revendications précédentes, **caractérisé en ce que** l'on utilise des éléments (4) en forme de soies ou de plaques souples et flexibles,

5. Procédé selon l'une quelconque des revendications précédentes, **caractérisé en ce que** les 616nents (4) en forme de soies ou de plaques sont formés de fer, d'un acier ou d'un alliage de ceux-ci.

6. Procédé selon l'une quelconque des revendications précédentes, **caractérisé en ce que** l'on utilise des éléments (4) en forme de soies ou de plaques qui sont formés d'un matériau, dont la dureté est inférieure à 50 % de la dureté du carbone dur formant le revêtement (2).

7. Procédé selon l'une quelconque des revendications précédentes, **caractérisé en ce que** les éléments (4) en forme de soies ou de plaques sont déplacés à une vitesse d'au moins 1 m/s le long de la surface du revêtement (2).

8. Procédé selon l'une quelconque des revendications précédentes, **caractérisé en ce que** l'on traite un revêtement formé de a-C, de ta-C ou de diamant.

9. Procédé selon l'une quelconque des revendications précédentes, **caractérisé en ce que** l'on assure, par le biais du métal contenu Jans les éléments (4) en forme de soies ou de plaques, un transfert de matériau dans les creux non entièrement remplis du revêtement (2).
